(19) Europäisches Patentamt
European Patent Office
Office européen des brevets

(11) **EP 2 413 440 A2**

(12) **EUROPEAN PATENT APPLICATION**

(43) Date of publication:
**01.02.2012 Bulletin 2012/05**

(51) Int Cl.:
*H01S 5/0683* (2006.01)    *H01S 5/022* (2006.01)
*H01S 5/183* (2006.01)

(21) Application number: **11175596.3**

(22) Date of filing: **27.07.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **28.07.2010 US 845570**

(71) Applicant: **Downing, John P. Jr.**
**Port Townsend, WA 98368 (US)**

(72) Inventors:
• **Downing, John P. Jr.**
**Port Townsend, WA 98368 (US)**
• **Babic, Dubravko Ivan**
**Santa Clara, CA 95050 (US)**

(74) Representative: **Eisenführ, Speiser & Partner**
**Postfach 10 60 78**
**28060 Bremen (DE)**

(54) **High-stability light source system and method of manufacturing**

(57) The present invention relates to a light source having a light emitter structured to emit a light beam of linearly polarized light having a peak wavelength in a wavelength band, a beamsplitter having a first optical surface structured to reflect a first portion of the light beam and transmit a second portion of the light beam, the beamsplitter having an optical coating disposed on the first optical surface of the beamsplitter, the first optical surface structured to define a plane of incidence, characterized in that the optical coating has characteristic parameters $F_{TE}$ and $F_{TM}$ that are given for a range of angles of incidence and for wavelengths $\lambda$ within the wavelength band, wherein $F_{TE}$ is defined as the ratio of power transmittance and power reflectance for light waves with polarization direction perpendicular to the plane of incidence, and $F_{TM}$ is defined as the ratio of power transmittance and power reflectance for light waves with polarization direction parallel to the plane of incidence, and the parameters $F_{TE}$ and $F_{TM}$ exhibit the following property: either ($dF_{TE}/d\lambda > 0$ and $dF_{TM}/d\lambda < 0$) or ($dF_{TE}/d\lambda < 0$ and $dF_{TM}/d\lambda > 0$).

Figure 6A

**Description**

BACKGROUND

Technical Field

The present disclosure pertains to the generation of light and, more particularly, to a light source system that generates stable optical power over time and temperature.

Description of the Related Art

Constant-intensity light sources are commonly used in industrial, medical, and military applications where the light intensity has to remain unchanged under varying ambient conditions, such as temperature, pressure, and humidity. Since the optical and electrical properties of all light emitters, solid-state laser media, and optical materials vary with temperature and other ambient conditions, an absolutely stable light source does not exist. Instead, conventional light sources of varying stability are developed for specific applications.

Attributes of light sources that are critical for specific applications may include wavelength, spectral bandwidth, stability, power consumption, size and cost. When size and cost are the primary concerns, semiconductor lasers and light-emitting diodes are the light emitters of choice, and if simple beam-forming measures are required to confine the output light into a group of parallel rays, typically a collimating lens, vertical-cavity surface-emitting lasers (VCSELs) and resonant-cavity light-emitting diodes (RCLEDs) are particularly well suited for many applications because they have chip sizes smaller than 0.1 mm$^2$ and emit round conical beams of visible and near-infrared light with low beam divergence. Beam divergence is an angular measure of the increase in beam diameter with distance from a light emitter. Furthermore, commercially available micro-lenses and reflectors can be integrated directly with RCLEDs and VCSELs. Producing stable light intensity when temperature changes during operation, however, is a challenging design problem that generally results in increased size and cost of a light source. For this reason, light-source designers usually must sacrifice high stability for small size to create light sources for a particular application.

Optical sources used in fiber-optic communication systems and optical sensing typically require optical power levels that can vary by as much as 15% over 50°C. The level of control necessary to maintain constant light intensity can be achieved by placing a temperature sensor close to a semiconductor light emitter and using an electronic circuit that varies the drive current through a semiconductor light emitter to maintain nearly constant output light intensity. For example, see U.S. Patent No. 4,841,157. The main reason why this type of output control yields inadequate light source stability for many applications is that the output light intensities of semiconductor light emitters typically used for this purpose decline with time at unpredictable and uncontrollable rates.

In another conventional system, a fraction of the light emitted by a semiconductor light emitter is compared to a preset signal, and the drive current for the light-emitter is continuously adjusted to bring the output intensity to a desired value. This approach is common in nearly all fiber-optic modules and light sources in conventional sensing applications and results in light-intensity fluctuations less than 5% over 50°C. While photodetectors have been integrated within VCSEL chips, the control accuracy achieved with these detectors in the aforementioned systems is and will continue to be unsatisfactory for many applications.

For example, in certain applications, including without limitation laser scanning, water- and air-turbidity sensing, airborne-particle analysis, fog and visibility monitoring and blood-gas analysis require light sources with output intensities that change less ½ % over a 50°C range for various absorption, transmittance and light-scattering measurements would significantly benefit from miniature highly-stable light sources. A miniature light source is defined as a light source that can be driven from two AA alkaline batteries and is about the size of an ordinary marble (roughly 1 cm$^3$, or a JEDEC TO-5 package). These requirements exclude the implementation of thermoelectric coolers to maintain the temperature and wavelength at pre-set values because they consume a large amount of electrical power. In some applications, small size is not a limiting requirement such as in confocal microscopy, DNA sequencing, biomedical instrumentation, and flow cytometry. Diode-pumped solid-state lasers (DPSSL) and optically pumped semiconductor lasers (OPSL) that incorporate the disclosed intensity-stabilizing system without thermal electric coolers are needed for portable, battery-powered systems designed for these applications. Presently there are no such products on the market, while clearly there is a need in the industry for such light sources that remain stable under ambient temperature variation.

BRIEF DESCRIPTION OF THE SEVERAL VIEWS OF THE DRAWINGS

The foregoing and other features and advantages of the present disclosure will be more readily appreciated from the following detailed description when taken in conjunction with the following drawings, wherein:

Figure 1 is a functional diagram of a closed-loop control system for emitting light of controlled intensity formed in accordance with the present disclosure;

Figure 2 is a graph of polarization angle over a temperature range;

Figure 3 illustrates a beamsplitter in the form of an optically transparent wedge prism with angle definitions formed in accordance with the present disclosure;

Figures 4A and 4B show a monogram of $H \cdot F$ products versus temperature for various calibration polarization angles $\phi_0$ and an inset graph of the spectral scans of the $F$ ratio (T/R) for TM and TE polarizations of an exemplary coated single-surface beamsplitter, respectively, in accordance with the present disclosure;

Figure 5 illustrates relative error of the output power of a light source with a coated wedge beamsplitter formed in accordance with the present disclosure;

Figures 6A-6C illustrate embodiments of a stable light source apparatus formed in accordance with the present disclosure; and

Figure 7 contains Tables 1 and 2.

## DETAILED DESCRIPTION

In the following description, certain specific details are set forth in order to provide a thorough understanding of various disclosed embodiments. However, one skilled in the relevant art will recognize that embodiments may be practiced without one or more of these specific details, or with other methods, components, materials, etc. In other instances, well-known structures or components or both associated with light sources, including but not limited to light-emitting diodes, prisms, and mirrors, have not been shown or described in order to avoid unnecessarily obscuring descriptions of the embodiments.

Unless the context requires otherwise, throughout the specification and claims which follow, the word "comprise" and variations thereof, such as, "comprises" and "comprising" are to be construed in an open, inclusive sense that is as "including, but not limited to."

Reference throughout this specification to "one embodiment" or "an embodiment" means that a particular feature, structure or characteristic described in connection with the embodiment is included in at least one embodiment. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

As used in this specification and the appended claims, the singular forms "a," "an," and "the" include plural referents unless the content clearly dictates otherwise. It should also be noted that the term "or" is generally employed in its broadest sense, that is as meaning "and/or" unless the content clearly dictates otherwise.

The headings and Abstract of the Disclosure provided herein are for convenience only and do not interpret the scope or meaning of the embodiments.

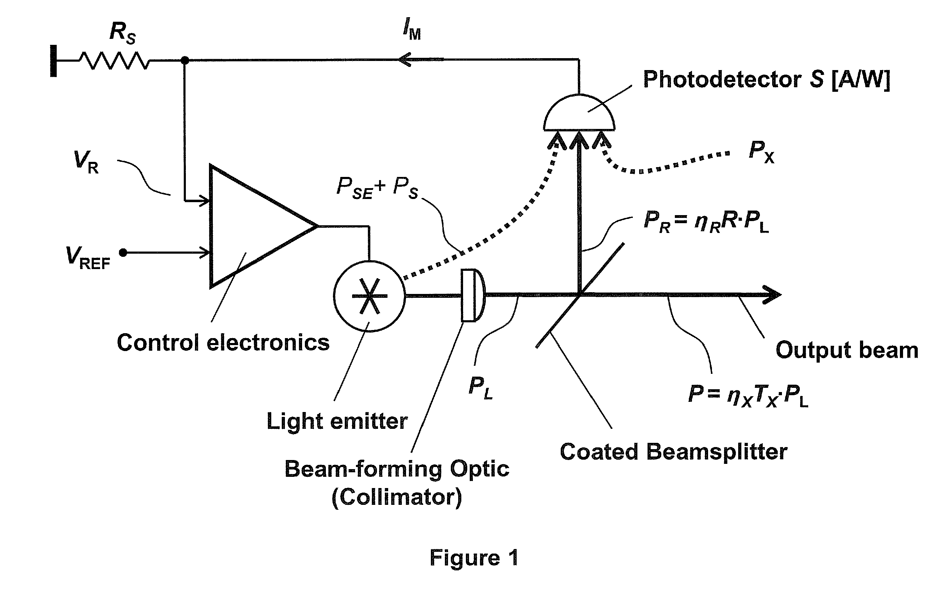

**Light-source system:** The present disclosure provides preferred embodiments of light-sources that uses a closed-loop control to maintain stable optical power in the output beam. A functional block diagram of a closed-loop control system for emitting light of controlled intensity formed in accordance with the present disclosure is illustrated in Figure 1. It includes a light emitter that emits a light beam of power $P_L$, a coated beamsplitter that reflects a fraction of the incident light with power reflectance R and transmits a fraction with power transmittance $T_X$, and a photodetector with responsivity S in A/W and associated control electronics. The light emitter can be any of the following continuous-wave lasers: (1) vertical-cavity surface-emitting lasers (VCSELs), (2) edge-emitting laser diodes (EELDs), (3) diode-pumped solid-state lasers (DPSSLs), and (4) optically pumped semiconductor lasers (OPSLs). The basic characteristics of these lasers are described herein below.

The reflected light power $P_R = \eta_R R \cdot P_L$ is coupled into the photodetector with coupling efficiency $\eta_R$. The phenomena that affect the coupling efficiency $\eta_R$ are discussed below. The light power $P_R$ is converted to electrical current $I_M = S \cdot P_R$ that passes through a sensing resistance $R_S$. The sensing resistance $R_S$ is used for illustration only, inasmuch as there is more than one way to generate electrical feedback in the control loop, as is known in the art. The control voltage $V_R = R_S \cdot I_M$ is compared to a pre-set reference voltage $V_{REF}$ and the voltage difference is used by the control electronics to adjust the intensity of the light captured by the photodetector such that $V_R$ equals $V_{REF}$ and constant output power $P_{OUT}$ is ideally maintained at a preset level. The transmitted or reflected (see later text) light is referred to as the *output beam*, which is specified by peak wavelength $\lambda_e$, spectral bandwidth, divergence angle, source-aperture size and other characteristics as required in a specific application. The output-beam power is $P_{OUT} = \eta_X T_X \cdot P_L$, where $\eta_X$ is the external coupling efficiency, which accounts for all factors that influence delivery of the output beam to its destination as discussed in later text. Systems, devices and electronic circuits that perform closed-loop control such as illustrated in Figure 1 are well known to those of skill in the technology and will not be described herein.

Preferred embodiments for the above-listed applications employ the functional block diagram shown in Figure 1, which includes novel optical design and manufacturing procedures. In one embodiment, the closed-loop control system shown in Figure 1 maintains a constant output intensity controlled by the $V_{REF}$ input while the light-emitter intensity and other system characteristics change with temperature, humidity, pressure, light-emitter age, and other phenomena that alter the relationship between the light-emitter drive current, or the pump current of DPSS and OPS lasers, and its output intensity.

The ability of a closed-loop system to maintain constant optical power in the output beam, especially while the temperature changes and the light-emitter optical power and beam quality degrade with time, is limited by the stability of the other components in the system. In the system shown in Figure 1, the control electronics will maintain $V_R \cong V_{REF}$ with an accuracy limited by noise and electronic component drift with temperature and the finite gain of the control loop. The difference between $V_{REF}$ and $V_R$ due to the foregoing causes is on the order of several parts per million (ppm), which is not significant in the disclosed systems. In addition to capturing light reflected from the beamsplitter, the photodetector may also capture external light $P_X$ that originates outside the light-source enclosure, spontaneous emissions $P_{SE}$ from the sides of a semiconductor light emitter and stimulated emissions scattered from a laser beam and light from any source reflected and diffracted by structures inside the package onto the photodetector, together referred to as stray light $P_S$. Collectively, $P_{SE}$, $P_S$ and $P_X$ will cause the control system to falsely reduce the optical power of the output beam from its preset level, producing a control error according to equation (1).

The functional relationships of significant phenomena that can affect the output power in the proposed light-source system are stated in equation (1).

$$P_{OUT} = \left(\frac{T_X}{R}\right) \cdot \left(\frac{\eta_X}{\eta_R}\right) \cdot \left(\frac{V_R}{SR_S} - P_{SE} - P_S - P_X\right)$$

$$(1)$$

A number of these phenomena change with ambient temperature as discussed below. Hereafter, the ratio $T_X/R$ is called the $F$ ratio and $S$ is a function of temperature and wavelength, while $S_0$ is the responsivity at a calibration temperature and wavelength, typically room temperature and calibration wavelength ($S_0$ is a constant). The parameter $H$ is defined by equation (2) and is a light source characteristic.

$$H(T,\lambda) = \frac{\eta_X}{\eta_R} \cdot \frac{S_0}{S}$$

$$(2)$$

Together with the external coupling coefficient $\eta_X$, the temperature variation of H in equation (3) can be calculated as:

$$\frac{1}{H}\frac{dH}{dT} = \frac{1}{\eta_X}\frac{d\eta_X}{dT} - \frac{1}{\eta_R}\frac{d\eta_R}{dT} - \frac{1}{S}\frac{dS}{dT} \ [\text{ppm}/°\text{C}]$$

$$(3)$$

Note that all the differentiations are total derivatives. By design, $d\eta_X/\eta_X dT$ and $d\eta_R/\eta_R dT$ can be made negligible to the photodetector temperature and wavelength sensitivity $dS/SdT$, hence $dH/H\ dT \approx -dS/SdT$. Using typical values for $\partial S/\partial\lambda \approx +750$ ppm/nm, $\partial S/\partial T = +40$ ppm/°C, and $d\lambda/dT = 0.08$ nm/°C in the analysis below, we will assume that $dH/HdT \approx -750 \cdot d\lambda/dT - 40 = -100$ ppm/°C. This sensitivity can be determined accurately by measurement or from manufacturer's specifications and will be used in the design procedure described below.

When any of the phenomena expressed in equation (1) change from their initial values in the operation of a light source, they can cause a relative control error, which is the change in the optical power of the output beam from a preset level relative to that preset level, which typically equals $P_{AVG}$ the output power averaged over a specified temperature range. The relative control error in output power $P_{OUT}$, expressed in ppm, is defined as:

$$D(T) = \frac{P_{OUT}(T) - P_{AVG}}{P_{AVG}} * 10^6$$

$$(4)$$

Hereafter, control error shall mean relative control error unless otherwise stated. The difference between the maximum and the minimum values of $D(T)$ is divided by the temperature range to define the relative control error per unit temperature expressed in ppm/°C. The relative control errors per unit of temperature for output power of the preferred embodiments are below 100 ppm °C$^{-1}$. A brief description of phenomena that affect the control accuracy of a closed-loop control system follows.

**Light emitters:** The embodiments of the present disclosure can accurately control the optical power emitted by a variety of collimated, coherent light emitters. Light emitters that are appropriate for the invention have the following common characteristics: (1) they emit a light beam of polarization-stable light in a single-mode; (2) they operate in continuous-wave CW or switched modes, wherein the switching frequency is less than a few kHz and the duty cycle is at least 10%; (3) their emission wavelengths vary with temperature in a substantially linear manner; and (4) they have spectral bandwidths less than about 0.5 nm. Operation in a switched mode is important for applications that require a phase-locked light emitter in a synchronous-detection, sensing system.

A preferred semiconductor light emitter is the polarization-locked, single-mode VCSEL. Single-mode VCSELs emit one longitudinal mode and one transverse mode and there is a single peak in their emission spectra. VCSELs are characterized by their *peak wavelength* (the wavelength corresponding to the maximum intensity of emitted light). The emitted wavelength of a VCSEL depends on the active material with which it is built. Other important spectral characteristics include the *spectral bandwidth*, which is the difference in the wavelengths at spectral points where the power is half the optical power at the peak wavelength and the side-mode-suppression ratio (SMSR), which is the power of the first higher mode relative to the fundamental mode expressed in deciBels (dB). Experiments performed by the inventers indicate that the preferred embodiment generally requires a minimum SMSR of 10 dB, and that an SMSR > 10 dB is a good first indication that a VCSEL emits substantially linearly polarized light. VCSELs have several peak wavelengths in the range of wavelengths from 400 nm to 1550 nm. In addition VCSELs have low threshold current, 1-4 mA, which is advantageous for battery-powered operation and nearly circular beams that requiring simple beam-forming optics.

Another preferred semiconductor light emitter is the single-mode edge-emitting laser diode EELD. Edge-emitting laser diodes have several peak emission wavelengths in the range of wavelengths from 400 mn to 1550 nm. Their spectral bandwidths are typically less than 0.5 nm and the degree of polarization typically exceeds 99%. Astigmatism and the inherently elliptical beam of an EELD make its emissions more difficult to collimate compared to VCSELs. Moreover, EELD threshold currents are roughly ten times higher than VCSELs and this makes them less desirable battery-powered systems.

Other light emitters that have appropriate characteristics are the diode-pumped solid-state laser DPSSL and the optically pumped semiconductor laser OPSL. The DPSSLs and OPSLs have several peak wavelengths in the range of wavelengths from 400 nm to 1550 nm. In addition, these lasers meet the other requirements regarding polarization properties and mode structure stated in above.

**Beamsplitters** reflect a first portion of a light beam to a photodetector and transmit a second portion to an output beam. Wavelength and polarization dependence of the transmitted and reflected beams are of particular concern in the construction of a high-stability light source as are interference fringes (etalons). Both of these phenomena are mitigated using the preferred design.

*Temperature dependence of optical properties:* In the system shown in Figure 1, the F ratio is the key factor determining the relative error and its variation with temperature that must be minimized to achieve high stability in the output light intensity - see equation (1). The wavelength and polarization dependence of F for any beamsplitter will be determined by the refractive index, angle of incidence, optical coatings that may be present on the beamsplitter, and interference fringes at the photodetector location and in the output beam. No matter how well designed a beamsplitter is, some wavelength and polarization dependence of the F ratio is inevitable. The inventors have found that uncontrolled wavelength and polarization dependences and the appearance of interference fringes (described below) present in commercially available beamsplitters make them unsuitable for use in the disclosure.

**Interference:** The beam emitted by a light emitter can experience interference as it is transmitted through an optical system. This type of interference is reminiscent of a Fabry-Perot resonator, or etalon, whose transmittance and reflectance spectra exhibit peaks or valleys, fringes, depending on whether the round trip between the reflections results in even (constructive interference) or odd (destructive interference) phase differences that are multiples of π. Interference produces unpredictable fluctuations in light intensity that can exceed 10,000 ppm/°C and can cause substantial control errors as the wavelength of light from a light emitter or solid-state laser varies with temperature. Interference can occur in any optical system when a beam of coherent light is split into two or more beams, which follow paths with different optical lengths to a light detector where they interfere constructively or destructively. Interference fringes can occur in beamsplitters (plates and cubes), epoxy-coated photodiodes, glass windows, lenses, and in free space wherever transmitted or reflected beams overlap and the distance between reflecting surfaces is less than the coherence length of the light emitter. Lasers suited for the present system have coherence lengths between millimeters and meters and hence there are potentially many arrangements of reflecting surfaces in the preferred system that can produce unwanted interference fringes.

The disclosed embodiments of the present disclosure achieve outstanding light source stability by optimizing the beamsplitter design and adjusting its free parameters based on the performance of the light emitter and the net change of photodetector S with wavelength and temperature. Wavelength, polarization drift, incidence angle of the light beam and the appearance of interference are the main phenomena that have to be managed in modifying a beamsplitter for the present purpose. The temperature dependence of other optical properties of the beamsplitter is generally significantly smaller.

**Drift in the beamsplitter $F$ ratio.** Single-surface beamsplitters with various shapes are used in the preferred embodiments. Detailed descriptions of these shapes are provided below. The $F$ ratio for a beamsplitter depends on the refractive index of the glass from which it is made and the optical properties of reflective coatings that may be applied to its surface. The wavelength, polarization angle, and angle of the incident light beam also affect $F$. As is well known in the art, these attributes of semiconductor light emitters and solid-state laser materials change with temperature. The $F$ ratios of coated beamsplitters are very sensitive to wavelength and incidence angle but less so to changes in polarization angle as defined below.

**Reflection coupling coefficient ($\eta_R$).** The phenomena that affect the reflection efficiency include the size of the photodetector light-sensing area, growth and decay of modes other than the primary one and pointing errors. Pointing errors are deflections of a light beam from an initial position as the temperature of a light emitter changes. These characteristics all change with drive currents and pump currents and the temperature of a semiconductor light emitter. It is well known that the emission angles of light emitters can vary with the drive current. The ability of the beamsplitter to reflect the entire light beam onto the photodetector without loss of intensity due to diffraction, apertures and field stops has to be temperature independent so as not to introduce control errors. As expressed in equation (1), an increase in $\eta_R$ will result in diminished power of the output beam.

**External coupling coefficient ($\eta_X$).** Changes in the beam profile that affect the output coupling are generally the same as those described for reflection coupling efficiency and in addition the entire beam must be delivered to the output device. An increase in $\eta_X$ will result in elevated optical power of the output beam in accordance with equation (1).

**Drift in the control voltage** $V_{REF}$ may result from fluctuations in power supply voltage. A high-quality voltage reference will drift about 10 ppm per °C.

**The responsivity ($S$)** is the amount of photocurrent produced per unit of light power captured by a photodetector. It depends on the wavelength of the detected light, detector temperature, and the position within the light-sensing area of the detector where the light is captured.

The amount of **spontaneous emission** $P_{SE}$ coupled into the photodetector will depend on the physical construction of the system and will generally be proportional to the drive current in a semiconductor light emitter. Methods to reduce the coupling of $P_{SE}$ onto the photodetector are described in later text.

The coupling of **scattered laser light** $P_S$ onto the photodetector will depend on the spatial extent of the beam and the reflection coupling coefficient. The sum of spontaneous emission and scattered laser light is referred to as *stray light.* Methods to reduce the coupling of $P_S$ onto the photodetector are described below.

**Diffraction:** The spreading of a light beam beyond the geometric limits of the emitter optics can alter the coupling of light to the photodetector and produce coupling errors in the reflected and output beams. These errors are factored into the $\eta_R$ and $\eta_X$ coefficients.

The intensity of **External light** $P_X$ generally depends on the physical design of a light source and the availability of external lighting, the orientation with respect to the sky and the time of day. It does not depend on temperature. External light can be rejected with optical filters, structures such as apertures, and synchronous detection as is well known in the art. Methods to reduce the coupling of $P_X$ onto the photodetector in the disclosed embodiments are described below.

*Temperature dependence of the lasing wavelength:* The lasing wavelength of VCSELs, EELDs , DPSSLs and OPSLs is determined by the round-trip time of a light wave in the laser cavity. It is well known that the refractive index of semiconductors and solid-state dielectrics constituting the laser cavity increase with temperature, and hence the round-trip time lengthens resulting in an increased emission wavelength. The variation in light emitter temperature and the associated change in light wavelength ultimately limit the accuracy that can be achieved by a system with a polarization-selective loss and without temperature regulation without the disclosed system. The rate of change of VCSEL emission wavelength with temperature $\beta \equiv d\lambda/dT$ is about 0.05 to 0.08 nm/°C and for EELDs it can be as high as 0.35 nm/°C. For an operating-temperature range of 50°C, wavelength can therefore vary by 2.5 to 17.5 nm and it affects the $F$ ratio of beamsplitters, the amount of light diffraction, and the intensity fluctuations caused by interference. It also affects the F ratio of anti-reflective (AR) and high-reflection HR optical coatings used in the system.

*Polarization Effects:* Any optical element with an F ratio that changes with the polarization of the light emitted by a light emitter can change the power of the output beam in the system depicted in Figure 1 and produce control errors. For this reason, the polarization characteristics of a light emitter selected for use in the preferred embodiments must be considered in the design process, carefully specified, screened during selection, and finally quantified during the manufacturing process. The screening, selection and characterization of light emitters are explained in later text.

The *plane of incidence* is the plane defined by the surface normal and the vector defining the direction of incoming radiation. Linearly polarized means there is no phase difference between the transverse electric and magnetic waves in a light beam and the plane of the electric field does not rotate with respect to the laser beam axis. A light beam in which the electric field rotates or has a random orientation with respect to a reference plane of the light emitter is unpolarized. The angle between the plane of electric-field oscillation, called the polarization direction, and another plane containing the laser beam axis and fixed in relation to the semiconductor laser (VCSEL or EELD), laser materials or components, or the plane of incidence of a beamsplitter or the transmission plane of a polarizer is the *polarization angle* $\phi$. In transverse electric (TE) incidence of linearly polarized light, the electric field is perpendicular to the plane of incidence. In the transverse magnetic (TM) incidence, the electric field of these beams is parallel to the plane of incidence. The polarization state of a reflection from a single air-dielectric surface is the vector sum of the orthogonal TE and TM vector components of an incident beams.

The degree of polarization expressed in percent = 100(Optical power in maximum polarization - Optical power in minimum polarization)/(Optical power in maximum polarization + Optical power in minimum polarization), Born and Wolf, *Principles of Optics,* Cambridge University Press (2002). The inventors have determined that to be useful in the disclosed highly-stable light source, the light beam has a degree of polarization of at least 80%.

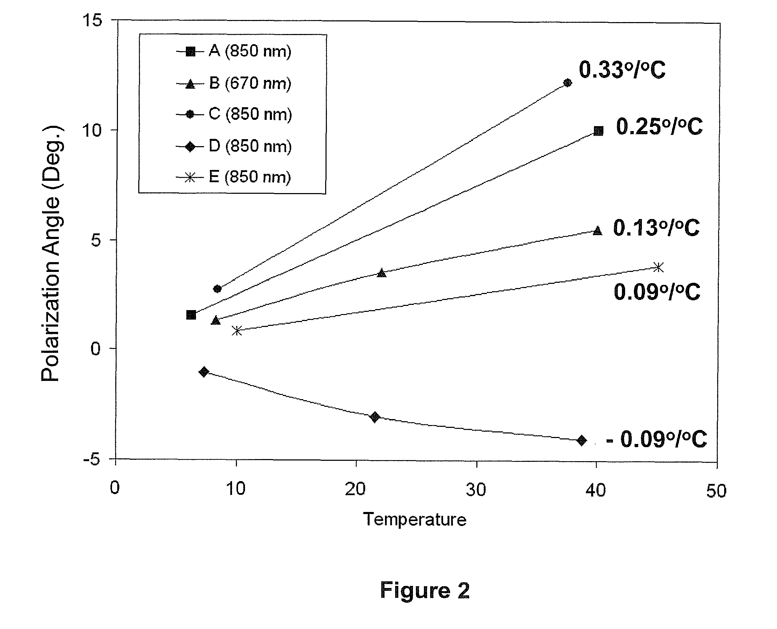

Polarization-locked VCSELs are commercially available with SMSR > 10 dB and maintain single-mode operation over a limited manufacturer-specified current range and temperature. Although the polarization of such lasers is "locked," meaning that it does not shift abruptly between TE and TM polarizations as temperature changes, the polarization angle can vary gradually and monotonically with junction temperature. Figure 2 shows the gradual variation of the polarization angles measured by the inventors on five polarization-locked VCSELs. The numerical values reported on Figure 2 represent the parameter $\gamma \equiv d\phi/dT$. Manufacturers generally do not provide information on the polarization characteristics of their light emitters or specifications for the polarization stability such as the examples shown on Figure 2. However, the inventers have determined that an SMSR ratio greater than 10 dB is a good first indication that a VCSEL emits substantially linearly polarized light. In one embodiment of the preferred method of manufacturing a high-stability light source, the light emitter is characterized for polarization angle as described in following text.

**Measurement of polarization angles:** Measurement of the full polarization characteristic of light emitters over the range of drive currents or temperatures required by a particular application is made using the rotating-polarizer method. The accuracy of the rotating-polarizer method does not depend on the extinction ratio of the polarizer. While the rotating-polarizer method is well known in prior art, its application in the present disclosure is unique. In the rotating-polarizer method, a light emitter is mounted in a fixed position on a temperature-controlled stage set to an initial temperature $T_0$ and the light emitter is driven using a constant-current source set to an initial drive current $I_0$. The output beam is passed through a polarizer and the transmitted beam intensity is measured with a polarization-insensitive photodetector. The light intensity is measured at many angles $\phi$ to determine the function $P(\phi)$, which is a sinusoidal function for a linearly polarized source. The stage is then changed to a different temperature $T_2$ and the drive current is set to maintain substantially the same maximum intensity as during the first step and the intensity function $P(\phi)$ is measured again. The lateral offset in degrees of angle between the curves gives the shift with temperature in polarization angle $\gamma$ of the light emitter. The data for VCSELs shown in Figure 2 were taken using the rotating-polarizer method.

In one embodiment of the preferred method of manufacturing a high-stability light source, the light emitter is characterized for polarization drift with temperature using the rotating-polarizer method described above.

**Photodetectors:** The closed-loop control system of Figure 1 relies on a semiconductor photodetector to convert light power to electrical power. The control error of the preferred high-stability light source will be limited by the drift in the responsivity of the detector with wavelength and temperature. Typical silicon and InGaAs photodetectors such as could be used in the present disclosure have responsivities that change with detected wavelength ($dS/Sd\lambda$) about 750 ppm/nm on average and $\pm 50$ ppm/°C (silicon) and $< \pm 800$ ppm/°C (InGaAs) with temperature ($dS/SdT\lambda$). The latter devices would need to be sorted to identify ones with $dS/SdT\lambda$ appropriate for a high-stability light source. In addition to wavelength and temperature, S varies over the active area of a photodiode. Some photodiodes exhibit variability having relative standard deviations in the 4-to-9 $10^{-4}$ range, which is acceptably small for the preferred embodiments of a high-stability light source. Photodetectors suitable for this application are the model S2387-series (silicon) and G6742-series (InGaAs) photodiodes manufactured by Hamamatsu, Japan. The temperature and spectral drifts of S in high-quality photodiodes are nearly linear and produce a net effect that can be factored into the $\eta_R$ coefficient and included in the optimization scheme discussed in later text. See equation (3).

**Single-surface beamsplitter:** A number of embodiments in which interference is eliminated or significantly reduced by the use of a wedge prism are disclosed. In a preferred embodiment of the disclosure, the beamsplitter is a wedge prism, made of an optically transparent, non-birefringent, dielectric material with the specular reflection and transmission at the first surface used to split the beam from a light emitter, while the reflection from the second surface is directed away from the detector and does not interference with the reflection from the first surface.

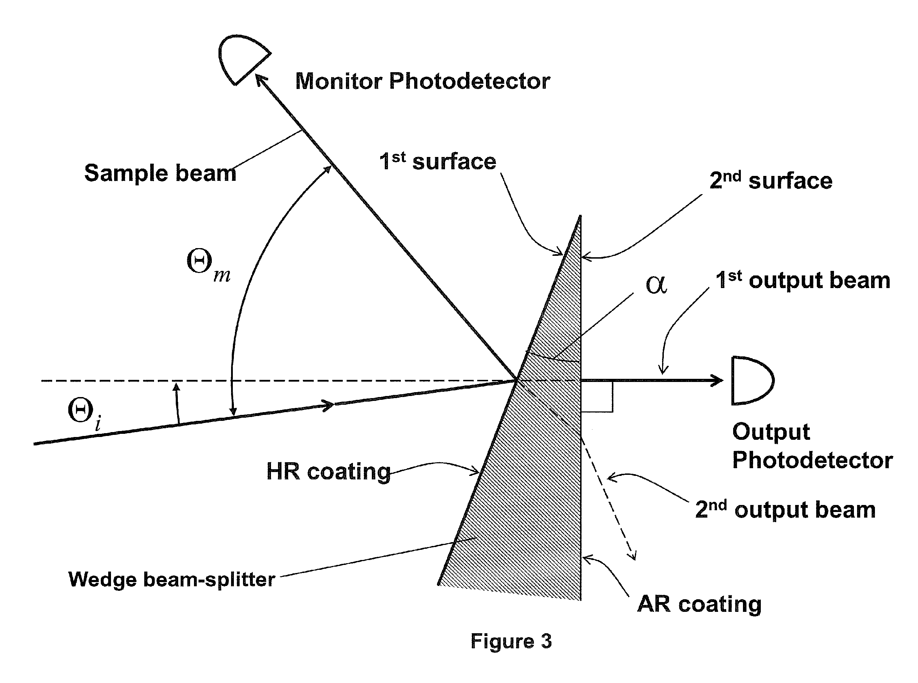

This embodiment is explained with the help of Figure 3. A beamsplitter shown therein is made of a rigid optically transparent dielectric material like glass with refractive index *n*, which has a first optical surface closing an acute angle

$\alpha$ with a second optical surface. By optical surface, we mean a surface that is used in a system to reflect or transmit light. The other surfaces of the wedge prism are not optical surfaces and can be implemented in many ways without departing from the disclosure. The incoming light beam is incident on the first optical surface (1st surface) and is reflected toward a photodetector (Sample beam) and is simultaneously transmitted as an output beam (1st output beam) to an output device illustrated as an output photodetector. The angle between the incident and the output beams (1st output beam) is given by $\theta_i$, while the angle between the incident and reflected beams (Sample beam) is denoted $\theta_m$, giving an angle of incidence $\theta_M/2$ at the first surface. In one embodiment, the first optical surface has an optical coating that may be a high-reflection (HR) coating. In another embodiment, the second optical surface of the wedge (2nd Surface) is coated with an anti-reflective coating that increases the transmittance of the beamsplitter and the intensity of the output beam (1st output beam).

In one embodiment, the 1st output beam is substantially normal to the second optical surface of the beamsplitter. In this case, the relationships between the angles $\theta_i$, $\theta_m$ and $\alpha$ for the preferred optically transparent wedge are given by equations 5 and 6.

$$\theta_i + \alpha = \frac{\theta_m}{2} \quad \text{and} \quad \theta_m = 2\sin^{-1}(n\sin\alpha) \qquad (5 \text{ and } 6)$$

The wedge angle $\alpha$ must exceed a critical value such that reflections from the first and second surfaces do not overlap at the photodetector and therefore do not interfere. In practice, wedge angles ($\alpha$) greater than several degrees are sufficient to prevent interference when using collimated, commercially available polarized light emitters.

The advantages of this preferred beamsplitter are (i) the angle $\alpha$ is sufficient to prevent the formation of interference fringes in the reflected beam at the photodetector and in the output beam at an output device and (ii) beam polarization has no effect on beam transmission through the second surface because the angle of incidence is 90°. The next sections explain the design of the high-stability light source addressing temperature and polarization dependence and assuming there is only one reflection from the beamsplitter.

*Reflection and transmission at a single air-dielectric surface:* The beam of a polarized light emitter is incident on the first optical surface of the beamsplitter (illustrated in Figure 3) at angle $\theta_M/2$ and is inclined towards the open end of the wedge. The $F$ ratio can be completely expressed for any polarization angle $\phi$ with the values of $F$ at the *TM* and *TE* polarization orientations:

$$F(\phi) = \frac{2(1+F_{TM})(1+F_{TE})}{(1+F_{TE})+(1+F_{TM})-(F_{TM}-F_{TE})\cos 2\phi} - 1 \qquad (7)$$

The $F$ ratio in equation (7) gives the dependence on all optical parameters in the beamsplitter structure, including $\lambda$, $\phi$, $\theta$ and n and it works for coated or uncoated single-surface beamsplitters.

*Coated single-surface beamsplitter for polarized light:* In a preferred embodiment of the present disclosure, the single-surface beamsplitter has a polarizing high-reflection HR coating designed for the range of wavelengths, called the *wavelength band*, over which it must provide compensation for temperature effects on polarization of a light emitter, photodetector sensitivity, coupling efficiency and other factors. It is determined by the manufacturing tolerance of the light emitter and the wavelength shift that will occur in normal operation. The primary advantage of such a coating is that its polarizing qualities can be engineered for improved stability compared to an uncoated beamsplitter for which these qualities are fixed by the optical properties of the dielectric material.

Taking VCSELs as an example light emitter, the shortest wavelength of this range $\lambda_{min}$ will equal the minimum wavelength in a batch of VCSELs less half of the wavelength change produced by the operating-temperature range. The maximum wavelength $\lambda_{max}$ will equal the longest wavelength in a batch of VCSELs plus the same wavelength change. These same properties are used to define wavelength bands for other light emitters such as EELDs, DPSSls, and OPSLs. Another important characteristic of the coating is that the slope of the $F$-ratio spectrum $F(\lambda)$ for the TE polarization have a sign opposite to the slope of the $F$-ratio spectrum for the TM polarization. $F_{TE}$ is the ratio of power transmittance and power reflectance for light waves with polarization direction perpendicular to the plane of incidence, and $F_{TM}$ is the ratio of power transmittance and power reflectance for light waves with polarization direction parallel to the plane of incidence. Moreover, it is advantageous to have the absolute magnitudes of these spectral slopes be approximately equal and further that the TE and TM spectra cross at one wavelength $\lambda_X$, which is preferably near the middle of the *wavelength band* as this is advantageous for requiring lowest accuracy in setting the *calibration angle* $\phi_0$. However, it can be near the minimum or maximum wavelengths or even outside the wavelength band by half its width and be in keeping with the spirit of the disclosure. In mathematical terms, $F_{TE} = F_{TM}$ at $\lambda_X$ and $dF_{TM}/d\lambda \approx -dF_{TE}/d\lambda$.

Yet another desirable feature of the $F_{TE}(\lambda)$ and $F_{TM}(\lambda)$ spectra is that they be substantially linear. Expressed as a ratio, the linearity of a monotonic function within a specified region equals 1.0 minus the ratio of the maximum deflection of the function from a straight line connecting its minimum and maximum values divided by its range over the region.

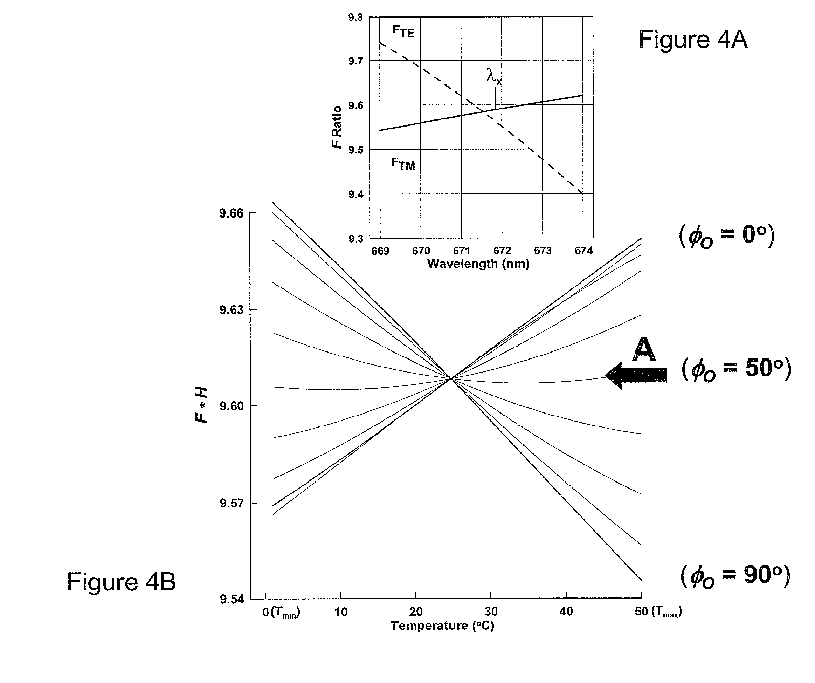

The exemplary $F$ curves in Figure 4A have a linearity > 0.85. Two independent parameters of a system that vary with temperature such as photodetector sensitivity and coupling efficiency can compensate for one another if their functions change with temperature with similar rates but in opposite directions. While the temperature-induced changes in the exemplary system are substantially linear, nonlinear curve shapes can be compensated by the method described herein and are in keeping with the spirit of the disclosure. Many characteristics of the $F$ and $H$ spectra are possible and exemplary characteristics described herein do not limit the scope of the disclosure.

We first discuss the variation of the F ratio. Figure 4A shows measurements of $F$ ratios for TM- and TE-polarized light beams incident at 45° upon an exemplary HR-coated, single-surface beamsplitter. The values $dF/(F \cdot dT)$ for TE and TM polarizations listed in Table 1 at 669 nm, 671.5 nm and 674 nm are greater by 10 to 100 times the corresponding values for an uncoated single-surface beamsplitter. Two important capabilities of the coating are: (i) the relative magnitude of $F_{TM}$ and $F_{TE}$ can be adjusted by design ($F_{TM}$ can be made larger, smaller, or equal to $F_{TE}$) over the wavelength band and (ii) the rate of change of $F_{TM}$ and $F_{TE}$ with wavelength, the spectral slope, can change in opposite directions. These features allow the sensitivity $dF/F \cdot d\phi$ and $H$ *values* to take both positive and negative values, which makes it an adjustable parameter that is used to compensate temperature variation of the other temperature dependent parameters in the system and allows very high stability in coated single-surface beamsplitters as described below.

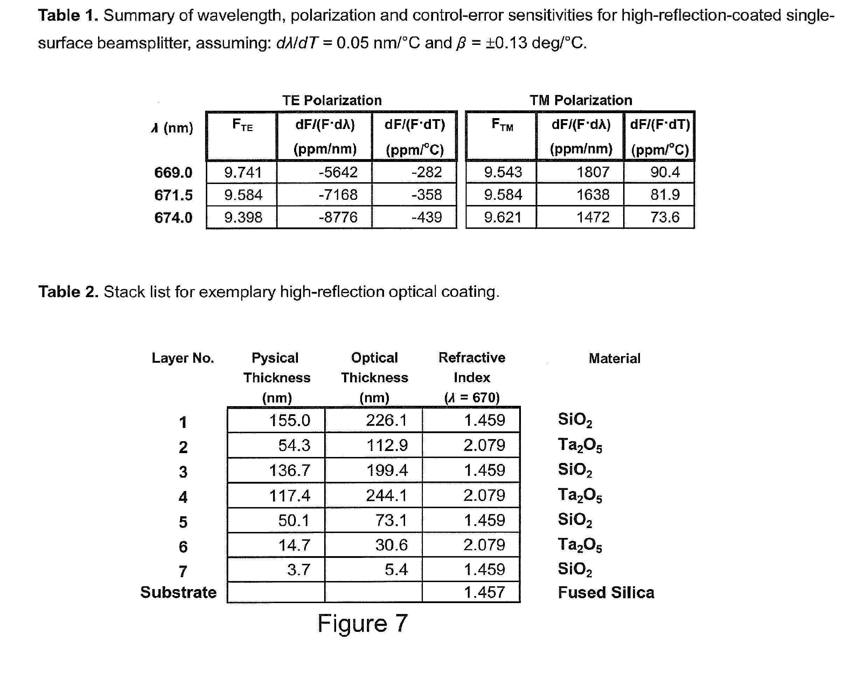

Table 2 shown in Figure 7 contains the stack list for an exemplary HR optical coating referenced in the description herein. This list gives the physical and optical thicknesses of the layers of dielectric materials comprising the coating illustrated in Figure 4A as well as their indices of refractions. The stack list is only an example as there are many ways to construct an HR coating for a single-surface beamsplitter so that it achieves the desired characteristics in the present invention.

The preferred method for realizing a highly-stable light source using a coated single-surface beamsplitter is described with the help of Figure 4B. Since the peak wavelength of a light emitter drifts with temperature approximately linearly, the $F$ ratios are multiplied by the $H$ values computed for specific temperatures to give the curves marked $\phi_0 = 0°$, $\phi_0 = 50°$, and $\phi_0 = 90°$ in Figure 4B. The high-stability light source is expected to operate over an *operating-temperature range* delimited by $T_{min}$ and $T_{max}$. The $F$ ratio for any angle $\phi$ can be calculated exactly using equation (7) where the $F_{TE}$ and $F_{TM}$ values are determined at the given temperature and drive current from the spectral scan of the optical coating provided by the manufacturer. The $F$ ratio is then multiplied by the $H$ parameter at the corresponding temperature calculated with equation (3).

Figure 4B shows the resulting exemplary $H \cdot F$ data when the calibration angle $\phi_0$ is incremented in steps of 10° from 0° (TM) through 90° (TE). For clarity, the 10° incremental steps from -90° to 0° are not shown. It is clear that if the starting angle $\phi_0$ is zero, it can be adjusted in both positive and negative directions, *i.e.*, clockwise and counter clockwise rotation of the light emitter about its beam axis. Two adjustment directions enable compensation for polarization drift in both positive and negative directions. For example, with $\phi_0 > 0$ and $\beta > 0$ an increase of polarization angle will decrease the $H \cdot F$ product, however a negative starting polarization angle $\phi_0 < 0$ and positive temperature coefficient ($\beta > 0$) will increase the $H \cdot F$ product with positive polarization drift. In this way, both polarities of polarization drift can be compensated using the preferred method.

The $H \cdot F(\phi)$ curves in Figure 4B therefore show the complete effects of light-emitter temperature and wavelength on the beamsplitter and the photodetector. For any initial setting $\phi_0$, the light emitter polarization angle may drift by an amount $(d\phi/dT)(T - T_0)$ when temperature is changed to a new value T. The new polarization angle is therefore given by $\phi(T) = \phi_0(T_0) + (d\phi/dT)(T - T_0)$. Figure 4B shows how the $H \cdot F$ product changes with temperature for an exemplary value of $\beta$ and starting polarization angle $\phi_0$ set at temperature $T_0 = 0°C$. The family of curves obtained by stepping the initial polarization angle and ramping temperature allows the designer to determine and numerically evaluate the optimal starting angle $\phi_0$ for the operating-temperature range.

The optimal calibration angle is found using a chart prepared for the actual optical coating, the photodetector properties and the coupling efficiencies of a particular highly-stable light source and by further identifying the value of $\phi_0$ for which the product of functions $H(T)$ and $F(T)$ approximates a horizontal line under the least square fit of the $H \cdot F$ products on temperature. For the data shown in Figure 4A, this line is located near the arrow **A**. It is clear that a light emitter with $d\phi/dT$ of either polarity ($\pm$) can be fitted as the calibration angle $\phi_0$ and therefore can change from positive to negative values.

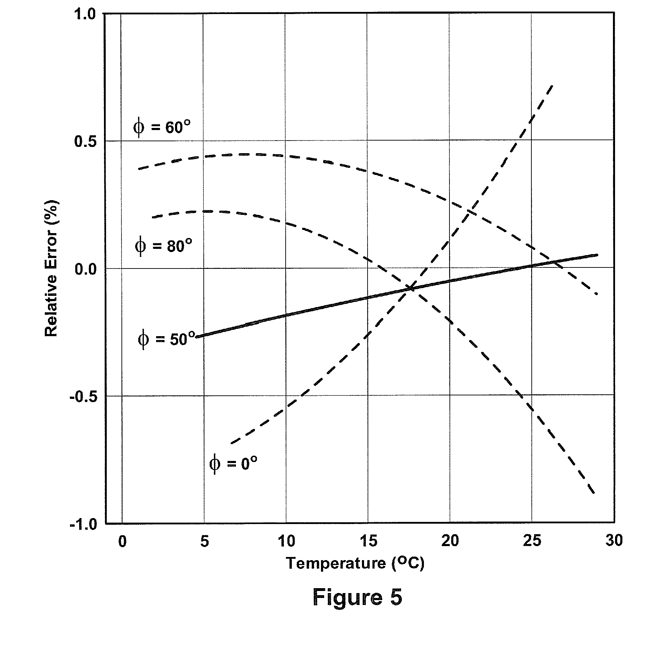

Figure 5 illustrates experimental data obtained by the inventors which demonstrate that a coated beamsplitter with a wedge angle of 5° can be used to realize highly-stable output as temperature varies. Figure 5 shows that the relative error for incidence at $\phi_0 = 50°$, expressed in percent, yields a relative control error per unit of temperature of 100 ppm/°C. The angle $\phi_0 = 50°$ is close to the calibration angle indicated by arrow **A** on Figure 4B. The curves for $\phi_0 = 20°$ and $\phi_0 = 80°$ have maximum values of 1.0% and relative errors of about 300 ppm/°C giving substantially larger errors than are realized by using the optimization procedure specified in later text.

*Conditions for Optimization of Coating for linearly polarized light:* An optimal coating is defined for a known variation of parameter $H$ over a specified wavelength band and range of angles of incidence. The range of angles of incidence is centered around 45 degrees. The temperature dependence of $H$ is converted to wavelength dependence using the factor $1/\beta = dT/d\lambda$ to give the function $H(\lambda)$ required for coating design. Any coating design is described using $F$ ratios for the TE and TM polarizations and their variation over the wavelength band and range of incidence angles, and to have error-compensating qualities, the slopes of the functions $H \cdot F_{TM}(\lambda)$ and $H \cdot F_{TE}(\lambda)$ must not be zero. In one embodiment, the preferred coating satisfies relationships $d(H \cdot F_{TE})/d\lambda < 0$ and $d(H \cdot F_{TM})/d\lambda > 0$ and in a variation of the embodiment, the inequalities in the relationships are simultaneously reversed. In other words, the slopes of the $F$ spectra of an optical coating on the single-surface beamsplitter have opposite signs. A further requirement of the design is that the coating satisfy the relationship $(dF_{TE}/d\lambda)/F_{TE} > -(dH/d\lambda)/H$ and $(dF_{TM}/d\lambda)/F_{TM} < -(dH/d\lambda)/H$ in the wavelength band and over the range of angles of incidence. Switching the parameters $F_{TE}$ and $F_{TM}$ in the foregoing relationship is an equivalent and satisfactory condition. The coating spectra should be specified for the manufacturer without the parameter $H$ because he cannot include it as a design parameter. The optimization procedure, however, must include it. In yet another variation, the optimal coating design exhibits at least one wavelength $\lambda_X$ preferably within the wavelength band at which $H \cdot F_{TE} = H \cdot F_{TM}$, however, $\lambda_X$ does not have to be in the wavelength band to function in accordance with the disclosure. The coating spectra will ideally be linear and therefore the location of $\lambda_X$ relative to the center of the wavelength band does not affect the maximum relative error and performance. The $F$ spectra of practical coatings, however, will invariably have curvature, they will be not be linear, and the slopes of the $F$ spectra, $F_{TE}(\lambda)$ and $F_{TM}(\lambda)$, change as the wavelength of the source departs from $\lambda_X$. This introduces errors that increase with $\lambda - \lambda_X$, and for this reason, it is preferred to operate near $\lambda_X$ and to have $\lambda_X$ be approximately centered within the wavelength band.

*Curvature and nonlinear compensating functions*: While it is preferred that the variation of parameters $H$ and $F$ with temperature as well as the functions describing factors to be compensated are substantially linear and independent of one another, the optimization scheme described herein works with nonlinear functions such as quadratics, polynomials, exponentials and the like. In order for a nonlinear function $H(\lambda)$ to be compensated by a function $F(\lambda)$, however the two must have "inverse" curvature over the compensation region. A simple graph showing the functions $R_{TE}(\lambda)$ and $R_{TM}(\lambda)$ over the desired wavelength band may suffice to express the desired spectral characteristics of the coating of a highly-stable light source. There are many alternative ways to specify the coating properties to realize the error-canceling benefits of the present embodiments and to maintain the spirit of the disclosure.

*The effect of angle of incidence uncertainty:* An unavoidable characteristic of coated and uncoated air-to-dielectric beamsplitters is that their $F$ spectra changes with the angle of incidence. Achieving an exact angle of incidence in production consistently will be a challenge if the tolerance of the angle of incidence is set too low. Small variations of the angle of incidence of the collimated beam on the first optical surface of the beamsplitter can shift the crossover wavelength of the $F$ spectra and change their curvature. Hence the design of the optical coating must accommodate variation of the angle of incidence as well as wavelength.

Design and adjustment of high-stability source made with an emitter of polarized light:

One embodiment of the preferred method of a high-stability light source made with an emitter of polarized light, a VCSEL in an exemplary system, is as follows:

1) The range of peak wavelengths ($\lambda_{MIN}$ and $\lambda_{MAX}$) and the change in peak wavelength with the temperature ($\beta$) of the light emitter are measured or obtained from accurate data supplied by the manufacturer for the light emitter.
2) The polarization state and change in polarization angle with the temperature ($\gamma$) of the light emitter are measured or otherwise obtained.
3) The variation of beam divergence with the temperature and drive current of the light emitter are measured or obtained from accurate data supplied by the manufacturer for the semiconductor light emitter.
4) The wavelength and temperature dependence of the photodetector responsivity, $\partial S/\partial \lambda$ and $\partial S/\partial T$, are measured or obtained from manufacturers' data.
5) The coupling efficiencies of the reflected $\eta_R$ and transmitted beams $\eta_X$ are determined from the beam divergence and the optical characteristics of the beamsplitter.
6) The parameters $H(\lambda, T)$ are computed using the values determined in steps four and five above.
7) The optical parameters of the beamsplitter are defined: at least the wedge angle $\alpha$ and refractive index of the glass. Based on this information, an optical coating is designed according to the specifications defined in the section above entitled "*Conditions for Optimal Coating Design for Linearly Polarized Light*".
8) The coating is manufactured and characterized for $F$ ratio as a function of wavelength: determining $F_{TE}(\lambda)$ and $F_{TM}(\lambda)$, and hence the complete function given with equation (7). The coating is characterized at the minimum and maximum incidence angle to verify that the curve slopes, curvature and crossover wavelengths are adequate.
9) A nomogram chart, illustrated in Figure 4B, is constructed numerically from the known data on the light emitter, photodetector, coupling coefficients, and the coating.

10) The optimal starting polarization angle $\phi_0$ for which the product $H(T)F(T)$ exhibits smallest variation over the operating-temperature range is determined by means of optimization (least square, for example).

11) The light-source system is built and the starting polarization angle $\phi_0$ is obtained by rotating the light emitter around its optical axis so that variation in intensity of the first portion or the second portion of the light beam over the operating-temperature range and over angles within the range of angles of incidence is at a minimum.

High-Stability Light Source Apparatus Design

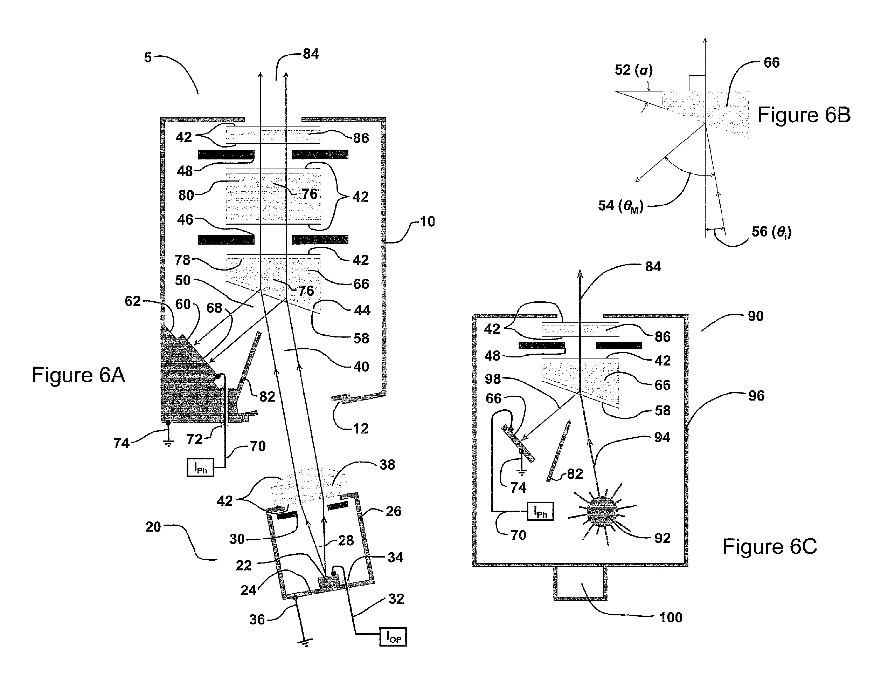

As shown in Figure 6A a preferred embodiment of a highly-stable light source 5 includes a housing 10 with a cavity 12 into which a light emitter can be inserted. The housing 10 is preferably formed of black ceramic or other rigid, light-absorbing material having a temperature expansion coefficient similar to those of the optical and semiconductor materials. The housing 10 can be a manufactured transistor outline (TO) metal package with a light-absorbing interior coating.

In a first variation of the highly-stable light source 5, the light-emitter 20 includes a semiconductor light emitter 22, preferably a VCSEL or EELD, that is fixed to the electrically conductive base 24 of an enclosure 26 so as to project a conical light beam 28 through an aperture 30. The conical light beam 28 contains substantially all of the stimulated emissions from the semiconductor light emitter 22. An electrical lead 32 passes through an insulator sleeve 34 and is connected to the anode of semiconductor light emitter 22 to allow current *Iop* to pass through it and control the output optical power. An electrical lead 36 is connected to an electrically conductive base 24 unto which the semiconductor light emitter 22 is bonded with solder or electrically conductive epoxy to provide a connection to the cathode of the semiconductor light emitter 22. The enclosure 26 contains substantially all of the spontaneous light emitted by the semiconductor light emitter and prevents it from reaching the photodetector 60. The housing 10 and the light emitter 20 are bonded to one another and hermetically sealed to form a protective enclosure around the light source 5.

The collimator lens 38 focuses the conical beam 28 from the semiconductor light emitter 22 into a collimated beam 40 of light rays that are substantially parallel to one another. Collimator lens 38 has anti-reflective coatings 42 to increase light transmission through it. The height of the enclosure 26 sets the focal length of the collimator lens 38. The collimated beam 40 is incident upon the first optical surface 44 of a beamsplitter 66, which is made of a transparent non-birefringent dielectric material (glass) that preferably has a high index of refraction such as SF11 or N-LaSF9. The wedge angle 52 ($\alpha$), reflection angle 54 ($\theta_M$), and deviation angle 56 ($\theta_i$) of the beamsplitter are determined by equations 6 and 7 as illustrated on Figure 6B. The reflection angle 54 is shown to be 60°; however, any acute angle between 50° and 90° can be used and the benefit of reduced interference from external light will be realized. The beamsplitter 66 is fixed to the housing base with a suitable adhesive or clamp.

The first optical surface 44 of beamsplitter 66 has a high reflectivity (HR) optical coating 58 that reflects a portion of the collimated beam 40 to form a reflected beam of light 50. The spectral properties of the HR optical coating 58 have been described above. The HR optical coating 58 increases the intensity of the reflected beam and the control signal strength ($V_R$) and has other advantages previously explained above. The apertures 30, 46, and 48 are preferably dimensioned to be approximately 1.5 times the diameter of the collimated beam 40, in order to reduce the intensity of external light entering the housing 10 and to block external light from directly impinging on the photodetector 60. Stray light scattered from the collimated beam 40 and external light that is internally reflected from the housing is prevented from impinging upon the photodetector 60 by a light baffle 82 attached to the housing 10 and positioned adjacent the photodetector 60.

The photodetector 60 is mounted on the electrically conductive base 62 of the housing 10 with solder or conductive epoxy to receive the reflected beam 50. The photodetector 60 is mounted so that its light-sensing area 68 is oriented perpendicular to the reflected beam 50 with its geometric center coincident with the beam axis. An electrical lead 70 passes through an insulator sleeve 72 and is connected to the anode of photodetector 60 to conduct photocurrent $I_{PH}$ to the control electronics (not shown) for the source 5. An electrical lead 74 connects to the electrically conductive base 62 and the cathode of the photodetector 60. The length and width of the first optical surface 44 and light-sensing area 68 must be sized to intersect substantially all the reflected beam 50 over the full operating-temperature range of the light source 5. The transmitted beam 76 passing through the first optical surface 44 is normally incident upon the second optical surface 78, which has an antireflective coating 42 that prevents substantially all reflection of the transmitted beam from the second optical surface 78 and thereby increases the intensity of the transmitted beam 76 and the overall efficiency of the light source 5. The transmitted beam 76 passes through aperture 46 whereupon it is incident on an optical filter 80 having anti-reflective coatings 42, which transmits substantially all of the power to the output beam 84 while attenuating most of the external light power $P_X$ that may enter the aperture 48 of the light source 5. A window 86 with anti-reflective coatings 42 is mounted over the aperture 48 and hermetically sealed to the housing 10 such that the optical axes of the optical filter 80 and the geometric center of second optical surface 78 are aligned with the optical axes of the transmitted beam 76 and the output beam 84. The optical filter 80 is not essential for the proper operation of the stable light-source system and is an optional feature.

Advantages of this structure over the prior devices are: (i) the solid angle of ambient light entering the unit through apertures 46 and 48 is substantially reduced from prior art intensities, and (ii) there is no direct light path by which external light can reach the photodetector 60 and said light is reflected by the first optical surface 44 of beamsplitter 50 away from the photodetector 60. Thus the highly-stable light source 5 with optical feedback in accordance with the disclosure has substantially reduced susceptibility to external light affecting automatic power control of the optical power of the output beam 84.

In a second variation of the preferred embodiment illustrated in Figure 6C, the beamsplitter 66, photodetector 60, aperture 46, light baffle 82 and widow 86 are incorporated in a commercially available laser module 90. The aforementioned components function in a manner identical to their function in the first variation of the disclosed embodiment in Figure 6A. The laser module 90 includes a diode-pumped solid-state or an optically pumped semiconductor laser 92 in a module enclosure 96. The laser 92 emits a collimated beam 94 that is incident upon the first optical surface 44 of the beamsplitter 66 having the HR optical coating 58 and a first portion 98 of the collimated beam 94 is reflected onto the photodetector 60. The photocurrent produced by the photodetector 60 provides signals through the electrical leads 70 and 74 to the power-control electronics of the laser module 90 in accordance with the closed-loop control system described previously and illustrated in Figure 1. A portion of the collimated beam 94 is transmitted through the coated beamsplitter 66, and then through the AR-coated window 86, to form the output beam 84. The laser module 90 is connected to support electronics by connector 84.

The polarization angle $\phi$ of the light-emitter 20 and the laser module 90 must be accurately determined such that the initial calibration polarization angle $\phi_0$ can be set during assembly. The procedure for determining the initial calibration polarization angle is explained above.

Thus in accordance with the present disclosure, a light source is provided that includes a light emitter structured to emit a light beam of linearly polarized light having a peak wavelength in a wavelength band, a beamsplitter having a first optical surface structured to reflect a first portion of the light beam and transmit a second portion of the light beam, the beamsplitter having an optical coating disposed on the first optical surface of the beamsplitter. The first optical surface is structured to define a plane of incidence, and the optical coating has characteristic parameters $F_{TE}$ and $F_{TM}$ that are given for a range of angles of incidence and for wavelengths $\lambda$ within the wavelength band, wherein $F_{TE}$ is defined as the ratio of power transmittance and power reflectance for light waves with polarization direction perpendicular to the plane of incidence, and $F_{TM}$ is defined as the ratio of power transmittance and power reflectance for light waves with polarization direction parallel to the plane of incidence, and the parameters $F_{TE}$ and $F_{TM}$ exhibit the following property: either ($dF_{TE}/d\lambda > 0$ and $dF_{TM}/d\lambda < 0$) or ($DF_{TE}/d\lambda < 0$ and $dF_{TM}/d\lambda > 0$).

In another embodiment, a device is provided that includes a light emitter operatively configured to emit a light beam of linearly polarized light, a photodetector, a beamsplitter having a first optical surface and a second optical surface that meet at an acute angle, the first optical surface of the beamsplitter structured to reflect a first portion of the light beam and to transmit a second portion of the light beam through the first optical surface and through the second optical surface in a direction that is substantially normal to the second optical surface. The first optical surface has an optical coating with characteristic parameters $F_{TE}$ and $F_{TM}$ that are given for a range of angles of incidence and for wavelengths $\lambda$ within a wavelength band, wherein $F_{TE}$ is defined as the ratio of power transmittance and power reflectance for light waves with polarization direction perpendicular to the plane of incidence, and $F_{TM}$ is defined as the ratio of power transmittance and power reflectance for light waves with polarization direction parallel to the plane of incidence, and the parameters $F_{TE}$ and $F_{TM}$ exhibit the following property: either ($dF_{TE}/d\lambda > 0$ and $dF_{TM}/d\lambda < 0$) or ($dF_{TE}/d\lambda < 0$ and $dF_{TM}/d\lambda > 0$).

In yet another embodiment, a method is provided for minimizing temperature sensitivity of a light output from a light source. The method includes providing an operating-temperature range, providing a range of angles of incidence for the light output, providing a light emitter operatively configured to emit a beam of linearly polarized light having an emission wavelength, and a beam polarization direction, the emission wavelength varying with temperature over the operating-temperature range, defining a wavelength band to include at least all emission wavelengths measured over the operating-temperature range, providing a photodetector having a responsivity, the responsivity varying with wavelength of incident light with wavelength in the wavelength band and with temperature over the operating-temperature range. The method further includes providing a beamsplitter having a first optical surface characterized by a parameter $F_{TE}$ and a parameter $F_{TM}$ specified for the wavelength band and for the range of angles of incidence, parameter $F_{TE}$ defined as the ratio of power transmittance and power reflectance for light waves with polarization perpendicular to a plane of incidence of the first optical surface, and parameter $F_{TM}$ defined as the ratio of power transmittance and power reflectance for light waves with polarization parallel to the plane of incidence, assembling the light source so that the light emitter is operatively configured to emit a light beam to be incident on the first optical surface, the first optical surface reflecting a first portion of the light beam and transmitting a second portion of the light beam, and rotating the light emitter around its optical axis to set a polarization angle between the plane of incidence of the first optical surface and the beam polarization direction for which variation in intensity of the first portion or the second portion of the light beam over the operating-temperature range and over angles within the range of angles of incidence is at a minimum.

Ideally, the first optical surface includes an optical coating disposed thereon, and the parameters $F_{TE}$ and $F_{TM}$ vary with a wavelength $\lambda$ as either ($dF_{TE}/d\lambda > 0$ and $dF_{TM}/d\lambda < 0$) or ($dF_{TE}/d\lambda < 0$ and $dF_{TM}/d\lambda > 0$) within the wavelength band and for all angles within the range of angles of incidence. Preferably, the method includes identifying at least one wavelength for which parameter $F_{TE}$ is equal to parameter $F_{TM}$.

There are many different structures and methods to configure the above listed components and to accomplish the stated functional objectives. Other combinations are possible and are in keeping with the spirit of the invention. The various embodiments described above can be combined to provide further embodiments.

The foregoing disclosure will have practical application in a variety of technologies. These include, without limitation, particle counting and sizing (air and water), reflectometers and gloss meters, visibility and fog meters, opacity meters, molecular light-scattering instrumentation, and turbidity meters.

All of the U.S. patents, U.S. patent application publications, U.S. patent application, foreign patents, foreign patent application and non-patent publications referred to in this specification and/or listed in the Application Data Sheet are incorporated herein by reference, in their entirety. Aspects of the embodiments can be modified, if necessary to employ concepts of the various patents, application and publications to provide yet further embodiments.

These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

**Table 1.** Summary of wavelength, polarization and control-error sensitivities for high-reflection-coated single-surface beamsplitter, assuming: $d\lambda/dT$ = 0.05 nm/°C and $\beta = \pm 0.13$ deg/°C.

| | **TE Polarization** | | | | **TM Polarization** | | |
|---|---|---|---|---|---|---|---|
| $\lambda$ (nm) | $F_{TE}$ | dF/(F·d$\lambda$) (ppm/nm) | dF/(F·dT) (ppm/°C) | | $F_{TM}$ | dF/(F·d$\lambda$) (ppm/nm) | dF/(F·dT) (ppm/°C) |
| **669.0** | 9.741 | -5642 | -282 | | 9.543 | 1807 | 90.4 |
| **671.5** | 9.584 | -7168 | -358 | | 9.584 | 1638 | 81.9 |
| **674.0** | 9.398 | -8776 | -439 | | 9.621 | 1472 | 73.6 |

**Table 2.** Stack list for exemplary high-reflection optical coating.

| Layer No. | Pysical Thickness (nm) | Optical Thickness (nm) | Refractive Index ($\lambda$ = 670) | Material |
|---|---|---|---|---|
| 1 | 155.0 | 226.1 | 1.459 | $SiO_2$ |
| 2 | 54.3 | 112.9 | 2.079 | $Ta_2O_5$ |
| 3 | 136.7 | 199.4 | 1.459 | $SiO_2$ |
| 4 | 117.4 | 244.1 | 2.079 | $Ta_2O_5$ |
| 5 | 50.1 | 73.1 | 1.459 | $SiO_2$ |
| 6 | 14.7 | 30.6 | 2.079 | $Ta_2O_5$ |
| 7 | 3.7 | 5.4 | 1.459 | $SiO_2$ |
| Substrate | | | 1.457 | Fused Silica |

**Claims**

**1.** A light source having a light emitter structured to emit a light beam of linearly polarized light having a peak wavelength in a wavelength band, a beamsplitter having a first optical surface structured to reflect a first portion of the light beam and transmit a second portion of the light beam, the beamsplitter having an optical coating disposed on the first optical surface of the beamsplitter, the first optical surface structured to define a plane of incidence, **characterized in that** the optical coating has characteristic parameters $F_{TE}$ and $F_{TM}$ that are given for a range of angles of incidence and for wavelengths $\lambda$ within the wavelength band, wherein $F_{TE}$ is defined as the ratio of power transmittance and power reflectance for light waves with polarization direction perpendicular to the plane of incidence, and $F_{TM}$ is defined as the ratio of power transmittance and power reflectance for light waves with polarization direction parallel to the plane of incidence, and the parameters $F_{TE}$ and $F_{TM}$ exhibit the following property: either ($dF_{TE}/d\lambda > 0$ and $dF_{TM}/d\lambda < 0$) or ($dF_{TE}/d\lambda < 0$ and $dF_{TM}/d\lambda > 0$).

**2.** The light source of claim 1, wherein there is at least one wavelength for which parameters $F_{TE}$ and $F_{TM}$ are equal.

**3.** The light source of claim 1, wherein the light beam has a degree of polarization of at least 80%, with the light beam having a beam polarization direction that closes an acute angle with the plane of incidence.

**4.** The light source of claim 1, wherein the light emitter is one from among a polarization-locked vertical-cavity surface-emitting laser, edge-emitting laser diode, diode-pumped solid-state laser, and an optically pumped semiconductor laser.

**5.** The light source of claim 1, wherein the range of angles of incidence is centered around 45 degrees.

**6.** The light source of claim 1, further comprising:

a photodetector; a collimating lens positioned between the beamsplitter and the semiconductor light emitter; and an enclosure to prevent stray light emitted by the light emitter from reaching the photodetector.

**7.** The light source of claim 6, further including a structure positioned to shield the photodetector from external light or stray light emitted by the light emitter.

**8.** A device that has a light emitter operatively configured to emit a light beam of linearly polarized light, a photodetector, a beamsplitter having a first optical surface and a second optical surface that meet at an acute angle, the first optical surface of the beamsplitter structured to reflect a first portion of the light beam and to transmit a second portion of the light beam through the first optical surface and through the second optical surface in a direction that is substantially normal to the second optical surface, the first optical surface having an optical coating, **characterized in that** the optical coating has characteristic parameters $F_{TE}$ and $F_{TM}$ that are given for a range of angles of incidence and for wavelengths $\lambda$ within a wavelength band, wherein $F_{TE}$ is defined as the ratio of power transmittance and power reflectance for light waves with polarization direction perpendicular to the plane of incidence, and $F_{TM}$ is defined as the ratio of power transmittance and power reflectance for light waves with polarization direction parallel to the plane of incidence, and the parameters $F_{TE}$ and $F_{TM}$ exhibit the following property: either ($dF_{TE}/d\lambda > 0$ and $dF_{TM}/d\lambda < 0$) or ($dF_{TE}/d\lambda < 0$ and $dF_{TM}/d\lambda > 0$).

**9.** The device of claim 8 further comprising a collimating lens positioned between the beamsplitter and the light emitter.

**10.** The device of claim 8, wherein the light beam has degree of polarization of at least 80%.

**11.** The device of claim 10, wherein the light emitter comprises a polarization-locked vertical-cavity surface emitting laser, a edge-emitting laser diode, a diode-pumped solid-state laser or an optically pumped semiconductor laser.

**12.** A method for minimizing temperature sensitivity of a light output from a light source, the method including providing an operating-temperature range, providing a range of angles of incidence for the light output, providing a light emitter operatively configured to emit a beam of linearly polarized light having an emission wavelength, and a beam polarization direction, the emission wavelength varying with temperature over the operating-temperature range, defining a wavelength band to include at least all emission wavelengths measured over the operating-temperature range, providing a photodetector having a responsivity, the responsivity varying with wavelength of incident light with wavelength in the wavelength band and with temperature over the operating-temperature range, **characterized in that** the method includes providing a beamsplitter having a first optical surface **characterized by** a parameter $F_{TE}$ and a parameter $F_{TM}$ specified for the wavelength band and for the range of angles of incidence, parameter $F_{TE}$ defined as the ratio of power transmittance and power reflectance for light waves with polarization perpendicular to a plane of incidence of the first optical surface, and parameter $F_{TM}$ defined as the ratio of power transmittance and power reflectance for light waves with polarization parallel to the plane of incidence, assembling the light source so that the light emitter is operatively configured to emit a light beam to be incident on the first optical surface, the first optical surface reflecting a first portion of the light beam and transmitting a second portion of the light beam, and rotating the light emitter around its optical axis to set a polarization angle between the plane of incidence of the first optical surface and the beam polarization direction for which variation in intensity of the first portion or the second portion of the light beam over the operating-temperature range and over angles within the range of angles of incidence is at a minimum.

**13.** The method of claim 12, wherein the first optical surface includes an optical coating disposed thereon, and the parameters $F_{TE}$ and $F_{TM}$ vary with a wavelength $\lambda$ as either ($dF_{TE}/d\lambda > 0$ and $dF_{TM}/d\lambda < 0$) or ($dF_{TE}/d\lambda < 0$ and $dF_{TM}/d\lambda > 0$) within the wavelength band and for all angles within the range of angles of incidence.

**13.** The method of claim 12, wherein the method includes identifying at least one wavelength for which parameter $F_{TE}$ is equal to parameter $F_{TM}$.

**14.** The method of claim 12, further comprising providing the beamsplitter with a second optical surface inclined at an acute angle relative to the first optical surface, and in which the second portion of the light beam has a direction substantially normal to the second optical surface.

$R_S$

$I_M$

Photodetector $S$ [A/W]

$V_R$

$P_{SE} + P_S$

$P_X$

$P_R = \eta_R R \cdot P_L$

$V_{REF}$

Control electronics

Light emitter

$P_L$

Output beam

$P = \eta_X T_X \cdot P_L$

Beam-forming Optic
(Collimator)

Coated Beamsplitter

Figure 1

EP 2 413 440 A2

Figure 2

Figure 3

EP 2 413 440 A2

Figure 4A

Figure 4B

Figure 5

Figure 6B

Figure 6C

Figure 6A

**Table 1.** Summary of wavelength, polarization and control-error sensitivities for high-reflection-coated single-surface beamsplitter, assuming: $d\lambda/dT$ = 0.05 nm/°C and $\beta$ = ±0.13 deg/°C.

| $\lambda$ (nm) | TE Polarization | | | TM Polarization | | |
|---|---|---|---|---|---|---|
| | $F_{TE}$ | dF/(F·d$\lambda$) (ppm/nm) | dF/(F·dT) (ppm/°C) | $F_{TM}$ | dF/(F·d$\lambda$) (ppm/nm) | dF/(F·dT) (ppm/°C) |
| 669.0 | 9.741 | -5642 | -282 | 9.543 | 1807 | 90.4 |
| 671.5 | 9.584 | -7168 | -358 | 9.584 | 1638 | 81.9 |
| 674.0 | 9.398 | -8776 | -439 | 9.621 | 1472 | 73.6 |

**Table 2.** Stack list for exemplary high-reflection optical coating.

| Layer No. | Pysical Thickness (nm) | Optical Thickness (nm) | Refractive Index ($\lambda$ = 670) | Material |
|---|---|---|---|---|
| 1 | 155.0 | 226.1 | 1.459 | $SiO_2$ |
| 2 | 54.3 | 112.9 | 2.079 | $Ta_2O_5$ |
| 3 | 136.7 | 199.4 | 1.459 | $SiO_2$ |
| 4 | 117.4 | 244.1 | 2.079 | $Ta_2O_5$ |
| 5 | 50.1 | 73.1 | 1.459 | $SiO_2$ |
| 6 | 14.7 | 30.6 | 2.079 | $Ta_2O_5$ |
| 7 | 3.7 | 5.4 | 1.459 | $SiO_2$ |
| Substrate | | | 1.457 | Fused Silica |

## Figure 7

EP 2 413 440 A2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4841157 A